# EUROPÄISCHE PATENTSCHRIFT

(11) **EP 1 312 929 B1**
(45) Veröffentlichungstag und Bekanntmachung des Hinweises auf die Patenterteilung: **05.04.2006**
(21) Anmeldenummer: 01127157.4
(22) Anmeldetag: 15.11.2001
(51) Int. Cl.: G01R 31/06, G01R 31/34

(54) **Verfahren zum Überwachen einer elektrischen Isolation eines Läufers einer elektrischen Maschine**
Method for monitoring the electrical isolation of a rotor in an electrical machine
Procédé de surveillance de l'isolation électrique d'un rotor dans une machine électrique

(43) Veröffentlichungstag der Anmeldung: 21.05.2003
(73) Patentinhaber: SIEMENS AKTIENGESELLSCHAFT, 80333 München (DE)
(72) Erfinder: Koziel, Reinhold, 45470 Mülheim a.d.Ruhr (DE)

(56) Entgegenhaltungen:
- DE-A- 19 623 808
- GB-A- 1 146 343

## Beschreibung

Die Erfindung betrifft eine elektrische Maschine mit einer Wicklungsisolationsüberwachung für eine Läuferwicklung.

Die Isolation einer Wicklung für eine elektrische Einrichtung, insbesondere einer elektrischen Maschine oder eines Transformators, kann vielfältige Fehler wie Isolationsfehler und dergleichen aufweisen. Gerade bei elektrischen Maschinen unterliegen die Wicklungen und daher auch die Wicklungsisolation einer besonderen mechanischen Belastung, die zu einer zusätzlichen Beanspruchung führt. Insbesondere sei hier auf die Wicklung eines Läufers der elektrischen Maschine abgestellt. Darüber hinaus wird die Wicklung der elektrischen Maschine auch durch den Betrieb an einem Umrichter besonders beansprucht, wie im Stand der Technik bekannt.

Um die Auswirkungen eines Isolationsfehlers gering zu halten, wird während des Betriebs der elektrischen Maschine die Isolation der Wicklung überwacht, beispielsweise um durch rechtzeitiges Abschalten der elektrischen Maschine größere Schäden zu vermeiden. Darüber hinaus kann der Ausfall einer elektrischen Maschine in einer proze8technischen Anlage zu gefährlichen Zuständen führen. In derartigen Fällen wird daher die Isolation einer elektrischen Maschine kontinuierlich überwacht.

Ein besonderes Augenmerk ist dabei auf die Isolation der Läuferwicklung zu legen, die zum Einen als mechanisch bewegtes, Element einer messtechnischen Überwachung schwerer zugänglich ist als die Ständerwicklung und zum Zweiten eine höhere Belastung als diese erfährt.

Zur Überwachung der Isolation der Läuferwicklung sind im Stand der Technik Verfahren und Vorrichtungen bekannt, bei denen beispielsweise ein Fehlerstrom mittels einer im Läufer angeordneten Meßeinrichtung ermittelt und ein entsprechendes Signal über Schleifkontakte an eine Überwachungseinrichtung übermittelt wird.

In dem Dokument DE 136 23 808 A1 wird beispielsweise eine Vorrichtung zur Messung von zumindest einer charakteristischen Zustandsgröße eines Erregessystems einer Läuferwicklung einer elektrodynamischen Mashine beschreiben. Diese Vorrichtung weist eine mit der Läuferwicklung ratierende Erzeugungseinrichtung auf, die ein magnetisches Feld erzeugt, das proportional zu der zu messenden Zustandsgröße des Erregessystems ist. Ferner weist die Vorrichtung eine feststehende Aufnahmeeinrichtung auf, in der mittels Induktion aus dem von der Erzeugungseinrichtung erzeugten, magnetischen Feld ein der Zustandsgröße proportionales Signal erzeugbar ist.

In dem dokument GB 1,146,343 wird ein Verfaren zur Messung von Strömen in Rotorsindungen von dynamolektrischen Maschinen beschrieben. Nach diesem Verfahren wird das lokale magnetische Feld gemessen, wobei dieses magnetische Feld mit einem ratierenden Leiter gekoppelt ist.

Daneben wird auch ein Ableitstrom einer isoliert montierten elektrischen Maschine als Maß für den Zustand der Isolation verwendet. Mit diesem Messverfahren können jedoch keine Winciungsschlüssewder Wicklung ermittelt werden.

Weitere Verfahren sehen eine am Läufer befestigte Elektronik vor, wobei hier die besondere mechanische Beanspruchung als nachteilig angesehen wird.

Als nachteilig wird empfunden, dass die Signale über Schleifkontakte übertragen werden. Einerseits unterliegen die Schleifkontakte einem Verschleiß und andrerseits kann der Betrieb der elektrischen Maschine unter bestimmten atmosphärischen Bedingungen und/oder Umgebungsbedingungen die Verwendung von Schleifkontakten verbieten.

Der Erfindung liegt daher die Aufgabe zugrunde, ein Verfahren und eine Vorrichtung zu schaffen, mit denen elektrisch kontaklos ein Isolationsfehler einer Wicklung auf einem rotierenden Element, insbesondere einem Läufer, einer elektrischen Maschine erkannt wird.

Dazu wird mit der Erfindung ein Verfahren zum Überwachen einer elektrischen Isolation eines Läufers einer elektrischen Maschine mit jeweils einer an jedem Ende einer Läuferwicklung in Reihe zu dieser angeschlossenen Spule vorgeschlagen, wobei sowohl ein magnetischer Leiter des Läufers, insbesondere ein Blechpaket, als auch ein über die beiden Spulen geschlossener Läuferstromkreis an einer Stelle zwischen den beiden Spulen elektrisch leitend mit einer Läufermasse verbunden sind, und

wobei durch einen Strom im Läuferstromkreis ein magnetisches Feld erzeugt wird, das magnetische Feld jeder Spule mittels eines entsprechenden Magnetfeldsensors kontaktlos gemessen und aus einer Änderung mindestens eines Messwerts eine Zustandsänderung der Isolation mittels einer Auswerteeinheit ermittelt wird.

Vorteilhaft kann eine Übermittlung von Messwerten über Schleifkontakte sowie die damit verbundenen Probleme vermieden werden. So kann beispielsweise die Genauigkeit von übertragenen analogen Messsignalen erhöht werden, da Störeinflüsse, wie eine Änderung des Übergangswiderstands eines Schleifkontakts keine Auswirkungen haben können. Ferner kann der Schleifkontakt bei kleinen Masssignalen dieses nicht mehr nachteilig beeinflussen. Darüber hinaus kann erreicht werden, dass die Stelle eines Isolationsfehlers der Wicklung ermittelbar ist. Dabei kann das Verfahren unabhängig von der Antriebsart als Generator oder als Motor bei Gleichstrommaschinen ebenso eingesetzt werden, wie bei Drehstrommaschinen, insbesondere Synchronmaschinen. Auf eine am Läufer vorgesehene Messelektronik kann verzichtet werden.

Weiterhin wird vorgeschlagen, dass die Spulen und/oder Magnetfeldsensoren derart geschaltet werden, daß bei einem an einer Stelle mit der Läufermasse elektrisch leitend verbundenen Läuferstromkreis ein Masseschluss durch ein Differenzsignal ermittelt wird. So kann beispielsweise durch die Art des Messsignals per se auf die Art eines Isolationsfehlers wie ein Windungsschluss oder ein Masseschluss geschlossen werden.

Mit der Erfindung wird ferner eine elektrische Maschine mit einem Läufer vorgeschlagen, der eine Läuferwicklung und einen magnetischen Leiter, insbesondere ein Blechpaket, aufweist, wobei zur Anwendung des Verfahrens nach einem der vorhergehenden Ansprüche an jedem Ende der Läuferwicklung in Reihe eine Spule angeschlossen ist, und wobei sowohl der magnetische Leiter des Läufers als auch ein über die beiden Spulen geschlossener Läuferstromkreis an einer Stelle zwischen den beiden Spulen elektrisch leitend mit einer Läufermasse verbunden sind, wobei die Spulen an einem axialen Läufende angeordnet sind. Hierdurch kann vorteilhaft erreicht werden, dass die Wicklungsisolation betreffende Messwerte erfasst, kontaktlos und im wesentlichen wartungsfrei für eine weitere Verarbeitung übertragen werden. Zudem kann eine unbeabsichtigte Beeinflussung der Messwerte beispielsweise durch Schleifkontakte vermieden und die Messgenauigkeit erhöht werden.

Die Anordnung der Spulen an dem axialen Läuferende wirkt vorteilhaft für die Messung erforderliche Magnetfeld in einem räumlich anderen Bereich als das Arbeitsmagnetfeld der elektrischen Maschine. Dadurch kann eine große Messempfindlichkeit sowie eine einfache Anordnung von Messsensoren erreicht werden.

Zudem wird vorgeschlagen, dass die Spule eine Topfspule ist. Die Topfspule kann ein auf einen kleinen räumlichen Bereich gerichtetes Magnetfeld erzeugen, wodurch in dem Bereich bei gegebener magnetischer Erregung ein gut auswertbares magnetisches Signal erzeugt werden kann. Auch kann eine Einwirkung von Störfeldern reduziert werden. Daneben können jedoch auch andere geeignete Spulenarten, wie Stabspulen oder mit magnetischem Ferritleiter versehene Spulen und dergleichen verwendet werden.

Ferner wird vorgeschlagen, dass zur Messung des magnetischen Feldes der Spulen jeweils ein mit einer Auswerteeinheit verbundener Magnetfeldsensor vorgesehen ist. Vorteilhaft wird aus dem magnetischen Feld der Spulen ein Messsignal gewonnen, welches von einer Auswerteeinheit verarbeitet werden kann. Dabei kann der Sensor aus einer weiteren Spule oder dergleichen bestehen und als Element der elektrischen Maschine vorgesehen sein. Daneben kann der Magnetfeldsensor auch an einer geeigneten Stelle als maschinenfremdes Element vorgesehen sein. So kann beispielsweise auch eine elektrische Maschine mit einer derartigen Messanordnung nachgerüstet werden.

Weiterhin wird vorgeschlagen, dass der Magnetfeldsensor ein Hall-Sensor ist. Als reaktionsschneller und genauer Messsensor ist das Hall-Element besonders zur Messung des magnetischen Feldes der Spulen geeignet. Darüber hinaus kann der Hall-Sensor eine kleine Bauform aufweisen und somit einfach in eine bestehende Maschinenkonstruktion integriert werden.

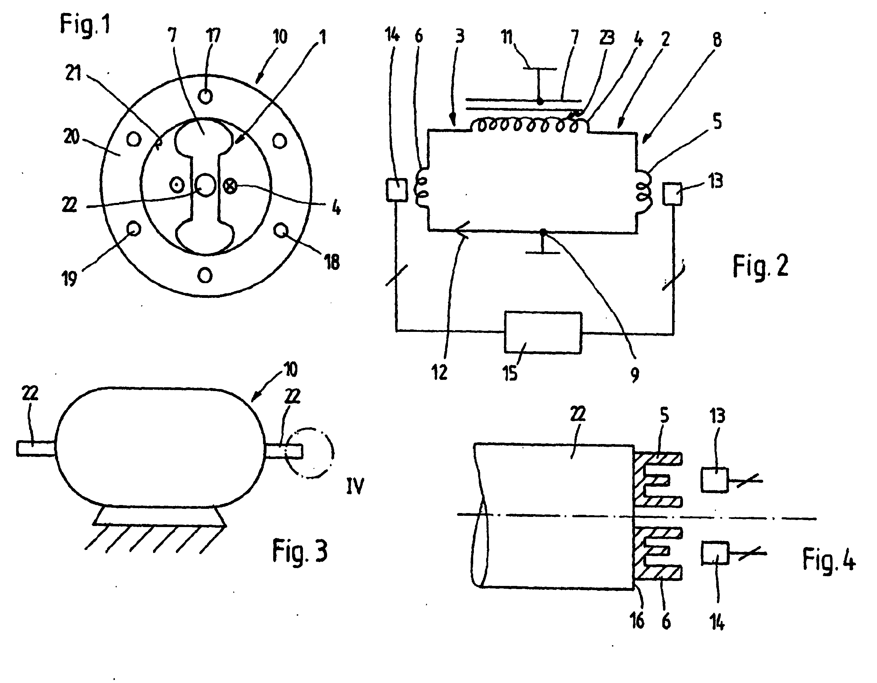

Weitere Einzelheiten, Merkmale und Vorteile der Erfindung sind der folgenden Beschreibung eines Ausführungsbeispiels zu entnehmen. Im wesentlichen gleichbleibende Bauteile sind mit den gleichen Bezugszeichen bezeichnet. Ferner wird bezüglich gleicher Merkmale und Funktionen auf die Beschreibung des Ausführungsbeispiels in Fig. 1 verwiesen.

Es zeigen:
- Fig. 1: einen Schnitt durch einen prinzipiellen Aufbau einer Synchronmaschine,
- Fig. 2: ein prinzipielles Schaltbild einer Anordnung zur Durchführung des erfindungsgemäßen Verfahrens,
- Fig. 3: eine Seitenansicht der Synchronmaschine und
- Fig. 4: eine Vergrößerung des Ausschnitts IV in Fig. 3.

Fig. 1 stellt einen Schnitt durch einen prinzipiellen Aufbau einer Synchronmaschine 10 dar. Ein zylindrisch ausgebildeter Ständer 20 mit einer inneren Öffnung 21 weist drei Ständerwicklungen 17, 18, 19 auf, die an die jeweilige Phase eines nicht weiter dargestellten Drehstroranetzes angeschlossen sind. Innerhalb der Öffnung 21 ist ein Läufer 1 drehbar gelagert. Der Läufer 1 weist eine Welle 22 auf.

Zum Überwachen einer elektrischen Isolation des Läufers 1 der Synchronmaschine 10 weist dieser an jedem Ende 2, 3 einer Läuferwicklung 4 in Reihe zu dieser angeschlossene Spulen 5, 6 auf (Fig. 2). Sowohl ein Blechpaket 7 des Läufers 1 als auch ein über die beiden Spulen 5, 6 geschlossener Läuferstromkreis 8 sind an einer Stelle 9 zwischen den beiden Spulen 5, 6 elektrisch leitend mit einer Läufermasse 11 verbunden. Durch einen Strom 12 im Läuferstromkreis 8 wird ein magnetisches Feld erzeugt. Das magnetische Feld jeder Spule 5, 6 wird mittels eines entsprechenden Magnetfeldsensors 13, 14 kontaktlos gemessen und aus einer Änderung mindestens eines Messwerts wird eine Zustandsänderung der Isolation mittels einer Auswerteeinheit 15 ermittelt. Die Auswerteeinheit 15 kann beispielsweise bei Überschreiten eines Grenzwertes einen Alarm auslösen und/oder die Synchronmaschine 10 abschalten.

Wenn beispielsweise zwischen zwei räumlich benachbarten Windungen der Läuferwicklung 4 ein Isolationsfehler auftritt, der einen Windungsschluss zur Folge hat, erhöht sich der Strom 12 im Läuferstromkreis 8, wodurch sich auch das durch die Spulen 5, 6 erzeugte magnetische Feld vergrößert. Diese Änderung des magnetischen Feldes wird durch die mit der Auswerteeinheit 15 verbundenen Hall-Sensoren 13, 14 erfasst. Die Auswerteeinheit 15 ermittelt eine Änderung und/oder eine Abweichung von vorgegebenen Grenzwerten. Bei Überschreiten eines Grenzwertes wird ein Alarm ausgelöst und die Synchronmaschine 10 abgeschaltet. Der Alarm kann dabei vor Ort durch eine Warnlampe oder auch als Meldung in einer entfernten Zentrale ausgeführt werden

Ferner werden die Spulen 5, 6 und/oder Magnetfeldsensoren 13, 14 derart geschaltet, daß bei einem an einer Stelle 9 mit der Läufermasse 11 elektrisch leitend verbundenen Läuferstromkreis 8 ein Masseschluss durch ein Differenzsignal ermittelt wird. Bei einem Isolationsfehler zur Läufermasse 7 entsteht ein weiterer Stromkreis über die Fehlerstelle 23 der Läuferwicklung 4 zum Blechpaket 7, vom Blechpaket 7 über die Läufermasse 11 zur Stelle 9 (Fig. 2). Der Strom 12, der die Spule 6 durchströmt, teilt sich an der Stelle des Isolationsfehlers auf, so dass durch die Spule 5 nur ein reduzierter Strom strömt. Diese Differenz wird durch die Auswerteeinheit festgestellt.

Zur Anwendung des Verfahrens ist in der Synchronmaschine 10 an jedem Ende der Läuferwicklung 2, 3 in Reihe jeweils eine Spule 5, 6 angeschlossen. Dabei sind die Spulen 5, 6 als Topfspulen ausgebildet (Fig. 3, 4). Durch die Ausführung der Spulen 5, 6 als Topfspule wird erreicht, dass zum Einen das magnetische Feld in Richtung Hall-Sensor konzentriert wird, um die Störbeeinflussung zu reduzieren und zum Zweiten mit geringem Energieaufwand die Messgenauigkeit erhöht werden kann.

Zur Messung des magnetischen Feldes der Spulen 5, 6 ist jeweils ein mit der Auswerteeinheit 15 verbundener Magnetfeldsensor 13, 14 vorgesehen.

Die Spulen 5, 6 sind hier an einem durch die Welle 22 gebildeten, axialen Läuferende 16 angeordnet. Unmittelbar davor sind die Hall-Sensoren 13, 14 angeordnet. Bei jeder Umdrehung der Welle 22 sind jeweils für einen entsprechenden Zeitaugenblick die beiden Spulen 5, 6 vor den entsprechenden Hall-Sensoren 13, 14, so dass eine Messung des magnetischen Feldes erfolgen kann.

Daneben kann die gesamte Anordnung auch innerhalb der Maschine 10 angeordnet sein, so dass eine abgeschlossene Baueinheit entsteht.

Das in den Figuren dargestellte Ausführungsbeispiel dient lediglich der Erläuterung der Erfindung und ist für dieses nicht beschränkend. So können insbesondere einzelne Verfahrensschritte als auch die zusätzlichen Funktionen wie Ermitteln der Fehlerart, usw. variieren.

## Patentansprüche

1. Verfahren zum Überwachen einer elektrischen Isolation eines Läufers (1) einer elektrischen Maschine (10) mit jeweils einer an jedem Ende (2, 3) einer Läuferwicklung (4) in Reihe zu dieser angeschlossenen Spule (5, 6), wobei sowohl ein magnetischer Leiter (7) des Läufers (1), insbesondere ein Blechpaket, als auch ein über die beiden Spulen (5, 6) geschlossener Läuferstromkreis (8) an einer Stelle (9) zwischen den beiden Spulen (5, 6) elektrisch leitend mit einer Läufermasse (11) verbunden sind,--und wobei durch einen Strom (12) im Läuferstromkreis (8) ein magnetisches Feld erzeugt wird, das magnetische Feld jeder Spule (5, 6) mittels eines entsprechenden Magnetfeldsensors (13, 14) kontaktlos gemessen und aus einer Änderung mindestens eines Messwerts eine Zustandsänderung der Isolation mittels einer Auswerteeinheit (15) ermittelt wird, **dadurch gekennzeichnet, dass** die Spulen (5,6) an einem axialen läuferende (16) angeordnet werden.

2. Verfahren nach Anspruch 1, **dadurch gekennzeichnet, dass** die Spulen (5, 6) und/oder Magnetfeldsensoren (13, 14) derart geschaltet werden, daß bei einem an einer Stelle (9) mit der Läufermasse (11) elektrisch leitend verbundenen Läuferstromkreis (8) ein Masseschluss durch ein Differenzsignal ermittelt wird.

3. Elektrische Maschine (10) mit einem Läufer (1), der eine Läuferwicklung (4) und einen magnetischen Leiter (7), insbesondere ein Blechpaket, aufweist, wobei zur Anwendung des Verfahrens nach einem der vorhergehenden Ansprüche an jedem Ende der Läuferwicklung (2, 3) in Reihe eine Spule (5, 6) angeschlossen ist, und wobei sowohl der magnetische Leiter (7) des Läufers (1) als auch ein über die beiden Spulen (5, 6) geschlossener Läuferstromkreis (8) an einer Stelle (9) zwischen den beiden Spulen (5, 6) elektrisch leitend mit einer Läufermasse (11) verbunden sind,
**dadurch gekennzeichnet**, das die Spulen (5, 6) an einem axialen Läuferende (16) angeordnet sind.

4. Elektrische Maschine nach Anspruch 3, **dadurch gekennzeichnet, dass** die Spule (5, 6) eine Topfspule ist.

5. Elektrische Maschine nach Anspruch 3 oder 4, **dadurch gekennzeichnet, dass** zur Messung des magnetischen Feldes der Spulen (5, 6) jeweils ein mit einer Auswerteeinheit (15) verbundener Magnetfeldsensor (13, 14) vorgesehen ist.

6. Elektrische Maschine nach einem der Ansprüche 3 bis 5, **dadurch gekennzeichnet, dass** der Magnetfeldsensor (13, 14) ein Hall-Sensor ist.

## Revendications

1. Procédé de surveillance d'une isolation électrique d'un rotor (1) d'une machine électrique (10) avec à chaque fois une bobine (5, 6) raccordée à chaque extrémité (2, 3) d'un enroulement de rotor (4) en série avec celui-ci, dans lequel un conducteur magnétique (7) du rotor (1), notamment un empilage de tôles, ainsi qu'un circuit de courant de rotor (8) fermé par l'intermédiaire des deux bobines (5, 6) sont reliés de façon électriquement conductrice à une masse de rotor (11) en un point (9) situé entre les deux bobines (5, 6), et dans lequel un champ magnétique est produit par un courant (12) dans le circuit de courant de rotor (8), le champ magnétique de chaque bobine (5, 6) est mesuré sans contact au moyen d'un capteur de champ magnétique correspondant (13, 14) et une variation d'état de l'isolation est déterminée au moyen d'une unité d'évaluation (15) à partir d'une variation d'au moins une valeur mesurée, **caractérisé par le fait que** les bobines (5, 6) sont disposées sur une extrémité de rotor (16) axiale.

2. Procédé selon la revendication 1, **caractérisé par le fait que** les bobines (5, 6) et/ou les capteurs de champ magnétique (13, 14) sont branchés de telle sorte que, avec un circuit de courant de rotor (8) relié de façon électriquement conductrice à la masse de rotor (11) en un point (9), un court-circuit à la masse est déterminé par un signal de différence.

3. Machine électrique (10) avec un rotor (1) qui comporte un enroulement de rotor (4) et un conducteur magnétique (7), notamment un empilage de tôles, dans laquelle, pour l'application du procédé selon l'une des revendications précédentes, une bobine (5, 6) est raccordée en série à chaque extrémité de l'enroulement de rotor (2, 3) et un conducteur magnétique (7) du rotor (1), notamment un empilage de tôles, ainsi qu'un circuit de courant de rotor (8) fermé par l'intermédiaire des deux bobines (5, 6) sont reliés de façon électriquement conductrice à une masse de rotor (11) en un point (9) situé entre les deux bobines (5, 6), **caractérisée par le fait que** les bobines (5, 6) sont disposées sur une extrémité de rotor (16) axiale.

4. Machine électrique selon la revendication 3, **caractérisée par le fait que** la bobine (5, 6) est une bobine pour noyau en pot.

5. Machine électrique selon la revendication 3 ou 4, **caractérisée par le fait que**, pour mesurer le champ magnétique des bobines (5, 6), il est prévu à chaque fois un capteur de champ magnétique (13, 14) relié à une unité d'évaluation (15).

6. Machine électrique selon l'une des revendications 3 à 5, **caractérisée par le fait que** le capteur de champ magnétique (13, 14) est un capteur à effet Hall.

## Claims

1. Method for monitoring electrical insulation on a rotor (1) of an electrical machine (10) having in each case one coil (5, 6), which is connected to each end (2, 3) of a rotor winding (4) and in series with it, in which both a magnetic conductor (7) of the rotor (1), in particular a laminated core, and a rotor circuit (8) which is closed via the two coils (5, 6) are electrically conductively connected to a rotor frame (11) at a point (9) between the two coils (5, 6), and in which a current (12) in the rotor circuit (8) produces a magnetic field, the magnetic field of each coil (5, 6) is measured without making contact by means of an appropriate magnetic field sensor (13, 14), and a state change in the insulation is determined from a change in at least one measurement value by means of an evaluation unit (15), **characterized in** the the coils (5, 6) are arranged at one axial rotor end (16).

2. Method according to Claim 1, **characterized in that** the coils (5, 6) and/or magnetic field sensors (13, 14) are connected such that a frame short is determined by a difference signal for a rotor circuit (8) which is electrically conductively connected to the rotor frame (11) at a point (9).

3. Electrical machine (10) having a rotor (1) which has a rotor winding (4) and a magnetic conductor (7), in particular a laminated core, in which, in order to use the method according to one of the preceding claims, a coil (5, 6) is connected in series to each end of the rotor winding (2, 3), and in which both the magnetic conductor (7) of the rotor (1) and a rotor circuit (8) which is closed via the two coils (5, 6) are electrically conductively connected to a rotor frame (11) at a point (9) between the two coils (5, 6), **characterized in that** the coils (5, 6) are arranged at one axial rotor end (16).

4. Electrical machine according to Claim 3, **characterized in that** the coil (5, 6) is a pot-type coil.

5. Electrical machine according to Claims 3 or 4, **characterized in that** a magnetic field sensor (13, 14) which is connected to an evaluation unit (15) is in each case provided for measuring the magnetic field of the coils (5, 6).

6. Electrical machine according to one of Claims 3 to 5, **characterized in that** the magnetic field sensor (13, 14) is a Hall sensor.
